# EUROPÄISCHE PATENTANMELDUNG

(11) **EP 2 308 949 A1**
(43) Veröffentlichungstag der Anmeldung: **13.04.2011**
(21) Anmeldenummer: 10186433.8
(22) Anmeldetag: 04.10.2010
(51) Int. Cl.: C09K 11/77, G21K 4/00

(54) **Szintillationsmaterial mit verbesserten Eigenschaften und Verfahren zur Herstellung derselben**

(30) Priorität: 09.10.2009 DE 102009045518
(71) Anmelder: Schott AG, 55122 Mainz (DE)
(72) Erfinder: von Saldern, Johann-Christoph, 07743 Jena (DE); Seitz, Christoph, 07745 Jena (DE); Parthier, Lutz, 14532 Kleinmachnowg (DE); Alkemper, Jochen, 55270 Klein-Winternheim (DE)
(74) Vertreter: Hrovat, Andrea Darinka

(57) **Zusammenfassung**

Die vorliegende Erfindung betrifft Szintillationsmaterialien auf Basis von Halogeniden, die aufgrund ihrer Zusammensetzung verbesserte Eigenschaften aufweisen. Insbesondere zeichnen sich die Szintillationsmaterialien der vorliegenden Erfindung durch hohe mechanische Stabilität und geringe Spannungsdoppelbrechung (SDB) und hohe Homogenität der Brechzahl (HOM) aus.

## Beschreibung

Die vorliegende Erfindung betrifft Szintillationsmaterialien auf Basis von Halogeniden, die aufgrund ihrer Zusammensetzung verbesserte Eigenschaften aufweisen. Insbesondere zeichnen sich die Szintillationsmaterialien der vorliegenden Erfindung durch hohe mechanische Stabilität und geringe Spannungsdoppelbrechung (SDB) und hohe Homogenität der Brechzahl (HOM) aus.

Szintillationsmaterialien des Standes der Technik weisen eine erhöhte Bruchempfindlichkeit auf, wodurch die Bearbeitbarkeit dieser Materialien deutlich erschwert ist. Herstellungsverfahren für bekannte Materialien führen zu geringen Ausbeuten. Diese Bruchempfindlichkeit wird im Wesentlichen durch Inhomogenitäten im Material, durch thermische Verspannungen und auch durch Kristalldefekte hervorgerufen.

Die mechanische Bearbeitbarkeit bekannter Materialien wie Trennen, Schleifen und Polieren, ist hierdurch stark eingeschränkt bzw. der hierfür benötigte Aufwand erhöht. Gleichzeitig nimmt der Ausschuss zu.

Wasser und Sauerstoff in den verarbeiteten Rohstoffen oder aus der Umwelt führen zur Bildung von Oxihalogenidverbindungen in der Schmelze. Während der Kristallisation führen diese dann aufgrund von Ausscheidungen zu Spannungen, welche die mechanischen Eigenschaften nachteilig beeinflussen und zu einer erhöhten Neigung zum Brechen führen. Außerdem setzen diese Verbindungen den "Light Yield", also die Lichtausbeute herab.

Die daraus resultierenden thermischen Verspannungen führen bei den Szintillationsmaterialien gemäß dem Stand der Technik zu einer erheblichen Spannungsdoppelbrechung und zu Inhomogenitäten in der Brechzahl. Diese Mängel sind mit ursächlich für die teilweise erheblichen Unterschiede der Szintillationseigenschaften und mechanischen Eigenschaften von Kristall zu Kristall, sofern es sich um einkristalline Materialien handelt.

US 7,405,404 B1 beschreibt ein CeBr₃ Szintillator, der zur γ- oder Röntgenstrahlen Detektion verwendet wird. Das CeBr₃ kann mit Lu, La, Eu, Pr, Sr, TI, Cl, F oder I dotiert sein. Die Dotanden sind mit mindestens 0,1 mol-% bis zu 100 mol-% enthalten. Y, Hf, Zr, Pd oder Bi sind als Dotanden nicht erwähnt. Desweiteren werden keine Angaben über die mechanischen Eigenschaften gemacht.

EP 1 930 395 A2 zeigt Szintillatorzusammensetzungen, die aus unterschiedlichen Vor-Szintillatorzusammensetzungen hergestellt werden. Die Vor-Szintillatorzusammensetzungen können als Hauptelemente Seltene Erden der Lanthanoidreihe und Bismut enthalten. Über die Verwendung von Bismut als Dotand wird keine Aussage gemacht. Desweiteren werden über die mechanischen Eigenschaften keine Angaben gemacht.

US 2008/0067391 A1 offenbart unter anderem einkristalline Szintillatoren mit der Formel Ln_{(1-y)}Ce_{y}X₃:M mit 0,0001< y <1. Ln ist mindestens ein Element ausgewählt aus den Lanthanoiden und X ist mindestens ein Halogenid. Der Dotand M ist mindestens ein Element ausgewählt aus der Gruppe Li, Na, K, Rb, Cs, AI, Zn, Ga, Be, Mg, Ca, Sr, Ba, Sc, Ge, Ti, V, Cu, Nb, Cr, Mn, Fe, Co, Ni, Mo, Ru, Rh, Pb, Ag, Cd, In, Sn, Sb, Ta, W, Re, Os, Ir, Pt, Au, Hg, TI und Bi.

Auch US 2008/0011953 A1 beschreibt eine Szintillatorzusammensetzung aus einer Matrix und einem Dotand. Die Matrix besteht aus mindestens einem Lanthanoidion und mindestens einen Halogenidion. Der Dotand ist ein Gemisch aus Cer und Bismut. Yttrium, Zirkonium, Palladium und Hafnium werden als Dotanden nicht vorgeschlagen.

Das Matrixmaterial besteht demnach aus zwei Kationen, nämlich neben dem Cer noch aus einem Lanthanoid. Nur ausnahmsweise kann das Lanthanoid selbst auch Cer sein, so dass die Matrix ein Cer-Halogenid ist.

Es besteht ein Bedarf an neuen Szintillationsmaterialien, die insbesondere auch in einkristalliner Form vorliegen können, die verbesserte Eigenschaften aufweisen. Dabei soll bei verbesserter Lichtausbeute gleichzeitig die intrinsische Spannungsdoppelbrechung vermindert sein. Ferner sollte die Brechzahl im Material homogen sein. Die verbesserten Materialien sollten in hoher Ausbeute und einfach herstellbar sein und dabei verbesserte mechanische Eigenschaften aufweisen.

Sofern das Szintillationsmaterial einkristallin vorliegt, sollten möglichst große Einkristalle herstellbar sein.

Erfindungsgemäß gelöst werden die oben genannten Aufgaben und Anforderungen durch ein Szintillationsmaterial, das eine Verbindung der Summenformel LnX₃:D umfasst, wobei Ln ausgewählt ist aus Sc, Y, La, Ce. Pr, Nd, Pm, Sm, Eu, Gd, Tb, Dy, Ho, Er, Tm, Yb, Lu, und X ausgewählt ist aus F, Cl, Br und I, wobei mindestens ein oder mehrere Dotand(en), ausgewählt aus Zirkonium, Hafnium und Bismut, in einer Menge von 10 ppm bis 10.000 ppm im Material vorliegent. Sofern es sich bei dem Basismaterial um Cerbromid handelt und Bismut als Dotand vorliegt, liegt in einem solchen Material mindestens ein weiterer Dotand, ausgewählt aus Yttrium, Zirkonium Hafnium und Palladium im Material vor.

Vorzugsweise besteht das Szintillationsmaterial aus der Verbindung der zuvor genannten Summenformel, was bedeutet dass dem Ausgangsgemisch außer den entsprechenden Komponenten und Dotanden keine weiteren Substanzen zugegeben werden. "Bestehend aus" soll nicht gängige Verunreinigungen ausschließen, die je nach Rohstoff im Material vorliegen können, dessen Eigenschaft aber im Wesentlichen nicht beeinflussen.

Das erfindungsgemäße Szintillationsmaterial kann einkristallin, oder polykristallin vorliegen. Bevorzugt ist ein einkristallines Szintillationsmaterial, da erfindungsgemäß Einkristalle in vorzugsweiser Größe hergesellt werden können.

Sofern das Material polykristallin ist, sollten die einzelnen Kristallite in einer Art und Weise angeordnet sein, die ein möglichst isotropes Verhalten des jeweiligen Materials bedingt.

Die vorliegende Erfindung stellt Szintillationsmaterialien bereit, die es ermöglichen, große Einkristalle herzustellen. Mit der vorliegenden Erfindung wird es sogar ermöglicht, Einkristalle eines Volumens von größer 5 cm³ herzustellen. Geeignete Verfahren sind dem Fachmann grundsätzlich bekannt, dies sind beispielsweise das Bridgman oder Czochralski Verfahren. Dabei werden die Ausgangshalogenide mit einem oder mehreren der Dotanden zur Schmelze erwärmt und dann zur Kristallisation abgekühlt.

Gleichzeitig können die Szintillationsmaterialien der Erfindung in hoher Ausbeute hergestellt werden. Auch die Lichtausbeute der fertigen Materialien nimmt zu, da erfindungsgemäß deutlich niedrigere Verunreinigungen im Material enthalten sind. Verunreinigungen sind insbesondere Sauerstoff oder Restwasser.

Die Abklingzeit der Szintillationsmaterialien verkürzt sich.

Erfindungsgemäß wird dem Szintillationsmaterial also wenigstens ein Dotand zugegeben, der ausgewählt ist aus Y, Zr, Hf, Pd und Bi in einer Menge von 10 ppm bis 10.000 ppm.

Vorzugsweise liegt der Dotand oder liegen die Dotanden in Mengen von 50 ppm bis 5.000 ppm, weiter bevorzugt in Mengen von 100 ppm bis 1.000 ppm in Szintillationsmaterial vor.

Aufgrund des unterschiedlichen lonenradius der Dotanden D zu den Kationen der Gruppe Ln werden lokale Spannungen im Wirtskristall hervorgerufen. Bislang wurde angenommen, dass solche lokalen Spannungen nachteilig sind. Überraschenderweise konnte jedoch nun gefunden werden, dass diese die Gitterenergie erhöhen und zwar in dem Maße, dass die kritische Energie zur Rissbildung bzw. zur Fortschreitung von Rissen deutliche erhöht wird.

Beim Züchtungsprozess führen diese lokalen Spannungen zu weniger Kristallbaufehlern. Die durch den zur Zucht nötigen Gradienten erzeugten thermischen Spannungen werden nicht durch Defekte abgebaut (kein plastischer sondern elastischer Spannungsabbau). Dies führt zum einen zu einer geringeren thermischen Verspannung des Kristalls durch den Abkühlprozess.

Ferner führt die geringere Defektkonzentration zu einer Verringerung der nicht strahlenden Übergänge und damit zu einer Erhöhung der Lichtausbeute, des Light Yields, insbesondere ohne dabei die anderen Szintillationseigenschaften, wie die Abklingzeit und die Energieauflösung, negativ zu beeinflussen. In bevorzugten Ausführungsformen ist der mindestens eine Dotand D in einer Menge von 500 ppm bis 5.000 ppm im Szintillationsmaterial der Erfindung enthalten. Besonders bevorzugt ist ein Gehalt von 100 ppm, bevorzugt größer als 500 ppm bis zur Obergrenze von 1.000 ppm.

Es hat sich herausgestellt, dass das Szintillationsmaterial der Erfindung besonders vorteilhafte Eigenschaften aufweist wenn das Element Ln, das kationisch vorliegt, ausgewählt ist aus La, Ce, Lu, Pr und Eu. Vorzugsweise ist Ln ausgewählt aus La und Ce.

Das Anion X ist besonders bevorzugt ausgewählt aus Cl, Br und I, weiter bevorzugt ausgewählt aus Cl und Br. Am meisten bevorzugt ist das erfindungsgemäße Szintillationsmaterial dotiertes CeBr₃. Sofern als Dotand Bismut in diesem Material vorliegt, liegt noch mindestens ein weiterer Dotand, ausgewählt aus Yttrium, Zirkonium, Hafnium und Palladium im Cerbromid vor.

Auch bevorzugt gemäß der vorliegenden Erfindung ist erfindungsgemäß dotiertes Lutetiumiodid und ebenso dotiertes Lanthanbromid.

Szintillationsmaterialien der oben beschriebenen Zusammensetzungen mit den erfindungsgemäßen Dotanden zeichnen sich durch eine ausgesprochene Härte auch bei Temperaturen nahe ihrem Schmelzpunkt aus. In der Folge werden weniger Kristalldefekte erzeugt und weniger Spannungen generiert.

Neben der Gitterhärtung durch Dotierung kann die mechanische Stabilität des Szintillationsmaterials zusätzlich durch ein geeignetes Abkühlregime und/oder einen Temperschritt im Herstellungsverfahren erhöht werden. Dadurch werden weitreichende Spannungen abgebaut.

Es ist daher bevorzugt, dass in einem Herstellungsverfahren des Szintillatormaterials der vorliegenden Erfindung nachfolgend beschriebene Abkühlbedingungen herrschen. Die Abkühlrate ist dabei bevorzugt unterhalb von 20 K/h, mehr bevorzugt 10 K/h und am meisten bevorzugt 5 K/h innerhalb des Temperaturbereiches von der Züchtungstemperatur bis 100°C. In einem Temperaturbereich bis 25°C liegt die Abkühlrate bevorzugt bei weniger als 40 K/h, weiter bevorzugt 20 K/h und am meisten bevorzugt 10 K/h. Durch Einhaltung dieser Bedingungen beträgt der maximale Temperaturgradient im Kristall weniger als 10 K/cm, bevorzugt weniger als 5 K/cm und am meisten bevorzugt weniger als 2 K/cm.

Beim Tempern wird ein homogenes Temperaturfeld angewendet mit einer Temperatur von maximal 10 K, bevorzugt 50 K und am meisten 100 K unterhalb der Schmelztemperatur des Materials. Der Temperaturgradient ist dabei kleiner 2 K/cm, bevorzugt kleiner 1 K/cm und am meisten bevorzugt kleiner 0,5 K/cm. Die Aufheiz- und Abkühlraten sind im Temperschritt wie beim Abkühlprozess zu wählen.

Das so erhaltene Szintillationsmaterial zeichnet sich durch eine Spannungsdoppelbrechung von kleiner als 1 µm/cm, bevorzugt kleiner 50 nm/cm und am meisten kleiner 10 nm/cm aus. Neben der Spannungsdoppelbrechung wird durch eine geeignete Temperung auch die Brechzahlhomogenität deutlich verbessert. Damit sind PV-Werte von besser als 10⁻³ zu erzielen.

Zur Vermeidung des Eindringens von Sauerstoff in den Kristall werden in der Züchtungsatmosphäre kohlenstoffhaltige Gase, vorzugsweise Kohlenstoffhalogenide, insbesondere CCl₄, CBr₄, Cl₄ zugesetzt. In Abhängigkeit von den Züchtungsbedingungen, insbesondere Druck und Temperatur, reagieren diese Gase mit dem Sauerstoff, wobei sich Carbonoxihalogenide bilden, welche sich in der Gasatmosphäre anreichern und nicht in den Kristall eingebaut werden. Auf diese Weise ist der entsprechende Kristall nahezu frei von Sauerstoff.

Insbesondere Seltenerd-Oxihalogenidverbindungen können unter diesen Bedingungen nicht entstehen. Ein so erhaltener Kristall zeichnet sich durch einen Sauerstoffgehalt von kleiner als 1.000 ppm aus.

Erfindungsgemäß beträgt die Hintergrundstrahlung des Szintillationsmaterials weniger als 0,5 Bq/cm³, was durch die hohe Reinheit des Materials ermöglicht wird. Verunreinigungen, die zu radioaktive Hintergrundstrahlung beitragen, werden auch Wahl entsprechend reiner Ausgangsverbindungen vermieden.

Die folgenden Beispiele dienen der Erörterung der Erfindung und sind nicht einschränkend für die entsprechenden Herstellungsverfahren. Insbesondere wird der Fachmann einen geeigneten Ofen wählen. Auch nicht festgelegt ist der Fachmann auf ein Bridgman Verfahren.

### Beispiel 1

Zur Herstellung eines erfindungsgemäßen Materials werden in eine Ampulle aus Quarzglas mit einem Innendurchmesser von 30 mm in einer mit Argon gefüllte "Glovebox", wobei Wasser und Sauerstoff zu weniger als 5 ppm in der Atmosphäre vorliegen, 500 g Cerbromid, 0,26 g BiBr₃ (entsprechend 0,125 g Bismut) und 0,29 g HfBr₃ (entsprechend 0,125 g Hafnium) eingewogen. Die Ampulle wurde anschließend evakuiert und mit 50 mbar Argon befüllt und abgeschmolzen. An der Spitze der Ampulle befindet sich eine 30 mm lange Kapillare mit einem Innendurchmesser von 3 mm. Die Ampulle wurde in einen 3 Zonen Bridgman Ofen verbracht. Zunächst wurde die Temperatur 48 Stunden lang bei 780°C gehalten. Anschließend wurde mit einer Absenkrate von 1 mm/h ein Kristall gezüchtet. Die Ampulle wurde in der Glovebox geöffnet und der Kristall entnommen.

### Beispiel 2

Zur Herstellung eines erfindungsgemäßen Materials werden in eine Ampulle aus Quarzglas mit einem Innendurchmesser von 30 mm in einer mit Argon gefüllte "Glovebox", wobei Wasser und Sauerstoff zu weniger als 5 ppm in der Atmosphäre vorliegen, 500 g Cerbromid, und 0,58 g HfBr₃ (entsprechend 0,25 g Hafnium) eingewogen. Die Ampulle wurde anschließend evakuiert und mit 50 mbar Argon befüllt und abgeschmolzen. An der Spitze der Ampulle befindet sich eine 30 mm lange Kapillare mit einem Innendurchmesser von 3 mm. Die Ampulle wurde in einen 3 Zonen Bridgman Ofen verbracht. Zunächst wurde die Temperatur 48 Stunden lang bei 780°C gehalten. Anschließend wurde mit einer Absenkrate von 1 mm/h ein Kristall gezüchtet. Die Ampulle wurde in der Glovebox geöffnet und der Kristall entnommen.

Die gemäß den Beispielen erhaltenen Kristalle zeigten im Vergleich zu einem undotierten Kristall eine 10% höhere Härte als ein analog hergestellter undotierter Kristall.

## Patentansprüche

1. Szintillationsmaterial umfassend eine Verbindung der allgemeinen Summenformel LnX₃:D, wobei Ln ausgewählt ist aus mindestens einem von Sc, Y, La, Ce, Pr, Nd, Pm, Sm, Eu, Gd, Tb, Dy, Ho, Er, Tm, Yb, Lu und X ausgewählt ist aus F, Cl, Br und I, und D ein kationischer Dotand, ausgewählt aus einem oder mehreren der Elemente Y, Zr, Pd, Hf und Bi ist und in einer Menge von 10 ppm bis 10.000 ppm im Material vorliegt, wobei ferner die Bedingung gilt, dass für Cerbromid als Szintillationsmaterial Bi als Dotand nur zusammen mit mindestens einem weiteren Dotand, ausgewählt aus Y, Zr, Pd und Hf im Material vorliegt.

2. Das Szintillationsmaterial nach Anspruch 1, wobei dieses aus der Verbindung mit der Summenformel LnX₃:D besteht.

3. Das Szintillationsmaterial nach Anspruch 1 und/oder 2, wobei der kationische Dotand in einer Menge von 50 ppm bis 10.000 ppm im Material vorliegt.

4. Das Szintillationsmaterial nach Anspruch 1 und/oder 2, wobei der kationische Dotand in einer Menge von 100 ppm bis 1.000 ppm im Material vorliegt.

5. Das Szintillationsmaterial nach einem oder mehreren der vorhergehenden Ansprüche, wobei dieses in einkristalliner oder polykristalliner Form vorliegt.

6. Das Szintillationsmaterial nach Anspruch 5, wobei das Material einkristallin ist.

7. Das Szintillationsmaterial nach einem oder mehreren der vorhergehenden Ansprüche, wobei Ln ausgewählt ist aus Lanthan, Lutetium und Praseodym.

8. Das Szintillationsmaterial nach einem oder mehreren der vorhergehenden Ansprüche, wobei Ln Cer ist und X Br ist.

9. Das Szintillationsmaterial nach einem oder mehreren der vorhergehenden Ansprüche, wobei X ausgewählt ist aus Cl und Br.
